# EUROPÄISCHE PATENTSCHRIFT

(11) **EP 4 419 925 B1**
(45) Veröffentlichungstag und Bekanntmachung des Hinweises auf die Patenterteilung: **07.10.2026**
(21) Anmeldenummer: 22786333.9
(22) Anmeldetag: 15.09.2022
(51) Int. Cl.: G01R 15/20, G01R 31/00, G01R 31/52, G01R 19/10, B60L 3/00, B60L 3/04, B60L 53/62

(54) **ÜBERWACHUNGSVORRICHTUNG FÜR EIN HOCHVOLT-BORDNETZ UND VERFAHREN ZUM BETREIBEN EINER ÜBERWACHUNGSVORRICHTUNG**
MONITORING DEVICE FOR A HIGH-VOLTAGE ONBOARD ELECTRICAL SYSTEM, AND METHOD FOR OPERATING A MONITORING DEVICE
DISPOSITIF DE SURVEILLANCE DE SYSTÈME ÉLECTRIQUE EMBARQUÉ À HAUTE TENSION ET PROCÉDÉ DE FONCTIONNEMENT D'UN DISPOSITIF DE SURVEILLANCE

(30) Priorität: 19.10.2021 DE 102021127098
(43) Veröffentlichungstag der Anmeldung: 28.08.2024
(73) Patentinhaber: Mercedes-Benz Group AG, 70372 Stuttgart (DE); Infineon Technologies AG, 85579 Neubiberg (DE)
(72) Erfinder: MAIER, Andreas, 73066 Uhingen (DE); MAIER, Peter, 73235 Weilheim (DE); RÖSSLER, Werner, 85375 Neufahrn (DE)
(74) Vertreter: RPK Patentanwälte Reinhardt und Kaufmann Partnerschaft mbB
(86) Internationale Anmeldenummer: PCT/EP2022/075643
(87) Internationale Veröffentlichungsnummer: WO 2023/066572

(56) Entgegenhaltungen:
- EP-A2- 2 384 922
- DE-A1- 10 253 018
- US-A1- 2009 085 573
- US-A1- 2018 067 172

## Beschreibung

Die Erfindung betrifft eine Überwachungsvorrichtung für ein Hochvolt-Bordnetz eines elektrisch betreibbaren Fahrzeugs sowie ein Verfahren zum Betreiben einer Überwachungsvorrichtung für ein Hochvolt-Bordnetz eines elektrisch betreibbaren Fahrzeugs.

Während des Ladevorgangs eines Hochvolt-Energiespeichers in einem Hochvolt-Bordnetz eines elektrisch betreibbaren Fahrzeugs werden sehr große Energiemengen umgesetzt. Dabei findet der Energiefluss von der Ladeinfrastruktur in Richtung Hochvolt-Energiespeicher statt. Weitere Hochvolt-Komponenten, wie beispielsweise der elektrische Antriebstrang, sind dabei passiv in das Hochvolt-Bordnetz eingekoppelt.

Im Wesentlichen werden in Kommunikationsnetzen in Fahrzeugen doppelte oder verstärkte Isolierungen angewendet oder die in den aus Gründen der elektromagnetischen Verträglichkeit (EMV) verwendeten Y-Kapazitäten gespeicherte Energie auf einen ungefährlichen Wert begrenzt. Zusätzlich werden Isolationsüberwachungseinrichtungen verwendet, die einen vorliegenden Körperschluss erkennen können. Bei bestimmten Fehlern im Ladekabel eines elektrisch betreibbaren Fahrzeugs kann bisher einzig eine Reduktion der in den Y-Kapazitäten gespeicherten Energie vorgenommen werden, da eine Isolationsüberwachung im Allgemeinen nicht über die erforderliche Reaktionsgeschwindigkeit verfügt und keine normative Anforderung an doppelte oder verstärkte Isolierung des Ladekabels besteht.

Die DE 10 2019 112 839 B3 offenbart eine Schutz- und Überwachungseinrichtung, die mindestens umfasst: einen Schutzleiter und mindestens eine mit dem Schutzleiter gekoppelte Sicherheitsleitungsschleife, eine sogenannte Pilotlinie, wobei die mindestens eine Sicherheitsleitungsschleife mindestens eine erste integrierte Schaltung, eine zweite integrierte Schaltung und eine Anzahl von Schaltelementen umfasst.

Die Schaltelemente sind jeweils mit mindestens einer mindestens eine elektrische Komponente der Ladeinfrastruktur überwachenden Überwachungseinrichtung bzw. Überwachungseinheit gekoppelt. Die erste integrierte Schaltung ist dazu konfiguriert, einen Takt eines die Sicherheitsleitungsschleife durchfließenden Stroms und/oder einer an die Sicherheitsleitungsschleife anzulegenden Spannung festzulegen und darüber hinaus einen Schaltzustand eines jeweiligen Schaltelements individuell festzustellen. Die zweite integrierte Schaltung ist dazu konfiguriert, den von der ersten integrierten Schaltung vorgegebenen Takt zu überprüfen. Die Sicherheitsleitungsschleife wird bei Betrieb der Ladeinfrastruktur über eine Stromeinspeisung über die erste integrierte Schaltung von einem Strom durchschlossen. Im Fall, dass für mindestens eine Überwachungseinheit eine sicherheitskritische Störung in Betriebsdaten der von ihr überwachten elektrischen Komponenten festgestellt wird, wird das mit der Überwachungseinheit gekoppelte Schaltelement geöffnet, die Sicherheitsleitungsschleife unterbrochen und dadurch die Ladeinfrastruktur entladen.

Die EP 2384922 A2, die DE10253018A1 und die US 2009085573 A1 offenbaren Überwachungsvorrichtungen für ein Hochvolt-Bordnetz von elektrisch betreibbaren Fahrzeugen. Die US 2018067172A1 offenbart zudem ein Verfahren zum Betreiben von Überwachungsvorrichtungen für ein Hochvolt-Bordnetz eines elektrisch betreibbaren Fahrzeugs.

Eine Aufgabe der Erfindung ist es, eine verbesserte Überwachungsvorrichtung für ein Hochvolt-Bordnetz eines elektrisch betreibbaren Fahrzeugs zu schaffen.

Eine weitere Aufgabe ist es, ein Verfahren zum Betreiben einer solchen verbesserten Überwachungsvorrichtung für ein Hochvolt-Bordnetz eines elektrisch betreibbaren Fahrzeugs anzugeben.

Die vorgenannten Aufgaben werden mit den Merkmalen der unabhängigen Ansprüche gelöst. Günstige Ausgestaltungen und Vorteile der Erfindung ergeben sich aus den weiteren Ansprüchen, der Beschreibung und der Zeichnung.

Nach einem Aspekt der Erfindung wird eine Überwachungsvorrichtung für ein Hochvolt-Bordnetz eines elektrisch betreibbaren Fahrzeugs vorgeschlagen, wobei das Hochvolt-Bordnetz wenigstens umfasst einen Hochvolt-Energiespeicher, welcher mit einer elektrisch positiven und einer elektrisch negativen Ladeleitung koppelbar ist, die elektrisch positive Ladeleitung, welche zum Laden des Hochvolt-Energiespeichers über einen Ladeanschluss mit einer positiven elektrischen Spannung einer Ladeeinrichtung koppelbar ist, und die elektrisch negative Ladeleitung, welche zum Laden des Hochvolt-Energiespeichers über den Ladeanschluss mit einer negativen elektrischen Spannung der Ladeeinrichtung koppelbar ist.

Dabei weist die Überwachungsvorrichtung eine Steuereinheit mit wenigstens einem Stromsensor auf, welcher zum Bestimmen einer Summe der elektrischen Ströme der positiven Ladeleitung und der negativen Ladeleitung ausgebildet ist. Die Steuereinheit ist ausgebildet, bei Erkennen eines Fehlerzustands die positive Ladeleitung und die negative Ladeleitung von dem Hochvolt-Bordnetz zu trennen.

Der Fehlerzustand wird aus einem zeitlichen Verlauf eines Stromintegrals der Summe der elektrischen Ströme abgeleitet, und ein Wert des Stromintegrals wird bei jeder Änderung der Stromrichtung der Summe der elektrischen Ströme auf Null gesetzt.

Tritt im Fehlerfall beispielsweise eine Körperdurchströmung auf Grund eines Isolationsfehlers oder sonstwie gearteten Kurzschlusses gegen Masse oder gegen den anderen der beiden Ladeleitungen auf, kann mit der erfindungsgemäßen Überwachungsvorrichtung ein Abschalten des Ladestroms vor Erreichen kritischer Werte der Körperdurchströmung bewirkt werden. Dazu wird die Summe der Ströme der positiven und negativen Ladeleitungen bestimmt, wobei die Ströme unterschiedliche Vorzeichen haben, da sie in entgegengesetzter Richtung fließen. In den weiteren Ausführungen bezieht sich der Begriff Summe der Ströme jeweils auf diese Summe der Ströme der positiven und negativen Ladeleitungen. Dies kann beispielsweise mit einem Hall-Sensor geschehen, beispielsweise mit einem sogenannten Open-Loop-Hall-Sensor, welcher den Strom durch Messung des Magnetfelds bestimmt. Wird über diesen Pfad ein Fehlerzustand erkannt, werden die Ladeleitungen beispielsweise durch unidirektionale Halbleiterschalter unterbrochen. Die Erkennung des Fehlerzustands basiert dabei auf einem Stromintegral, das bei jeder Änderung der Stromrichtung auf Null gesetzt wird und dessen Betrag mit einem Schwellwert verglichen werden kann. Die Werte des Stromintegrals können bedarfsweise auch gefiltert werden, um Offsetfehler in der Summe der Ströme zu kompensieren.

Eine Gefährdung durch ein Berühren des Leiters im Ladepfad kann somit unabhängig vom Energieinhalt von fahrzeugseitigen Y-Kapazitäten verhindert werden.

Zusätzlich ist eine Begrenzung von externen Kurzschlüssen auf Schmelzintegralwerte von unter 500.000 A²s durch die vorhandenen Halbleiterschalter möglich. Dieser Wert von 500.000 A²s wird beispielsweise in der Ladeschnittstellennorm CHAdeMO gefordert und beschreibt den Zusatznutzen, dass bei Kurzschlussereignissen in der Ladeeinrichtung die spezifische Wärmemenge, die aus der Batterie entnommen werden kann, zum Schutz der Ladeeinrichtung limitiert wird. Das wird üblicherweise mit Schmelzsicherungen bewirkt. Der Einsatz einer Schmelzsicherung mit so niedriger Auslöseschwelle begrenzt jedoch häufig den möglichen Ladestrom im Nennbetrieb, da ansonsten die Dauerhaltbarkeitsanforderungen nicht erfüllt werden können.

Gemäß einer vorteilhaften Ausgestaltung der Überwachungsvorrichtung kann der wenigstens eine Stromsensor ausgebildet sein, die Summe der Ströme über ein gemeinsames Magnetfeld der positiven und der negativen Ladeleitung zu bestimmen.

Als Stromsensor kommen alle Sensoren in Betracht, die eine Summe der Ströme ermitteln können, wie beispielsweise Hall-Sensoren oder magneto-resistive Sensoren. Vorteilhaft kann die Summe der Ströme über das gemeinsame Magnetfeld beider Ladeleitungen gemessen werden.

Gemäß einer vorteilhaften Ausgestaltung der Überwachungsvorrichtung kann der wenigstens eine Stromsensor als wenigstens einer von einem Hall-Sensor, insbesondere einem Open-Loop-Hall-Sensor, einem magneto-resistiven Sensor, einem Transformator ausgebildet sein.

Als Stromsensor kommen Sensoren in Betracht, die eine Summe der Ströme ermitteln können. So kann die Summe der Ströme über das gemeinsame Magnetfeld beider Ladeleitungen gemessen werden. Beispielsweise kann ein Hall-Sensor mit einem Magnetfeld-Konzentrator nach dem sogenannten open-loop hall effect eingesetzt werden. Ein solcher Hall-Sensor misst das Magnetfeld im Luftspalt eines stromdurchflossenen magnetischen Ringkerns und kann daraus den Strom bestimmen. Alternativ kann das Magnetfeld auch mit einem magneto-resistiven Sensor gemessen werden. Eine weitere Möglichkeit ist, einen Transformator einzusetzen, und so nur den Wechselstromanteil zu betrachten, welcher dann beispielsweise gefiltert werden kann.

Gemäß einer vorteilhaften Ausgestaltung der Überwachungsvorrichtung kann in der positiven und negativen Ladeleitung jeweils ein Schaltelement, insbesondere ein Halbleiterschalter angeordnet sein, um bei Erkennen des Fehlerzustands die positive Ladeleitung und die negative Ladeleitung von dem Hochvolt-Bordnetz zu trennen.

Als Halbleiterschalter können vorteilhaft Feldeffekttransistoren (FETs) eingesetzt werden. Beispielsweise können so SiC-FETs, GaN-FETs oder sogar normale Si-FETs verwendet werden.

Gemäß einer vorteilhaften Ausgestaltung der Überwachungsvorrichtung kann die Steuereinheit ausgebildet sein, das Erkennen des Fehlerzustands aus einem zeitlichen Verlauf des Stromintegrals der Summe der elektrischen Ströme abzuleiten.

Die Erkennung des Fehlerzustands basiert auf einem Stromintegral, das bei jeder Änderung der Stromrichtung auf Null gesetzt wird und dessen Betrag mit einem Schwellwert verglichen werden kann. Die Werte des Stromintegrals können bedarfsweise auch gefiltert werden, um Offsetfehler in der Summe der Ströme zu kompensieren.

Nach einem weiteren Aspekt der Erfindung wird ein Verfahren zum Betreiben einer Überwachungsvorrichtung für ein Hochvolt-Bordnetz eines elektrisch betreibbaren Fahrzeugs nach dem einen Aspekt der Erfndung vorgeschlagen, wobei das Hochvolt-Bordnetz wenigstens umfasst einen Hochvolt-Energiespeicher, welcher mit einer elektrisch positiven und einer elektrisch negativen Ladeleitung koppelbar ist, die elektrisch positive Ladeleitung, welche zum Laden des Hochvolt-Energiespeichers über einen Ladeanschluss mit einer positiven elektrischen Spannung einer Ladeeinrichtung koppelbar ist, die elektrisch negative Ladeleitung, welche zum Laden des Hochvolt-Energiespeichers über den Ladeanschluss mit einer negativen elektrischen Spannung der Ladeeinrichtung koppelbar ist.

Die Überwachungsvorrichtung weist eine Steuereinheit mit wenigstens einem Stromsensor aufweist. Dabei wird mittels des Stromsensors eine Summe der elektrischen Ströme der positiven Ladeleitung und der negativen Ladeleitung bestimmt.

Bei Erkennen eines Fehlerzustands durch die Steuereinheit werden die positive Ladeleitung und die negative Ladeleitung von dem Hochvolt-Bordnetz getrennt.

Der Fehlerzustand wird aus einem zeitlichen Verlauf eines Stromintegrals der Summe der elektrischen Ströme abgeleitet, und ein Wert des Stromintegrals wird bei jeder Änderung der Stromrichtung der Summe der elektrischen Ströme auf Null gesetzt.

Nach dem erfindungsgemäßen Verfahren kann mittels der Überwachungsvorrichtung ein Abschalten des Ladestroms vor Erreichen kritischer Werte einer Körperdurchströmung bewirkt werden. Dazu wird die Summe der Ströme der positiven und negativen Ladeleitungen, also der Summe des Stroms der positiven Ladeleitung und des Stroms der negativen Ladeleitung, bestimmt. Dies kann beispielsweise mit einem Hall-Sensor geschehen, beispielsweise mit einem sogenannten Open-Loop-Hall-Sensor, welcher den Strom durch Messung des Magnetfelds bestimmt.

Wird über diesen Pfad ein Fehlerzustand erkannt, werden die Ladeleitungen beispielsweise durch unidirektionale Halbleiterschalter unterbrochen. Die Erkennung des Fehlerzustands basiert dabei auf einem Stromintegral, das bei jeder Änderung der Stromrichtung auf Null gesetzt wird und dessen Betrag mit einem Schwellwert verglichen werden kann. Die Werte des Stromintegrals können bedarfsweise auch gefiltert werden, um Offsetfehler in der Summe der Ströme zu kompensieren.

Eine Gefährdung durch ein Berühren des Leiters im Ladepfad kann somit unabhängig vom Energieinhalt von fahrzeugseitigen Y-Kapazitäten verhindert werden.

Dadurch, dass der Fehlerzustand aus einem zeitlichen Verlauf eines Stromintegrals der Summe der elektrischen Ströme abgeleitet wird, kann eine zeitliche Änderung des Stromintegrals der Summe der elektrischen Ströme erkennen lassen, dass der elektrische Pfad, auf dem der Ladestrom eigentlich fließen sollte, sich geändert hat. Dies kann auf einen Isolationsfehler oder einen Körperschluss hindeuten, sodass rechtzeitig auf einen Fehler erkannt und die Ladeleitungen vom Hochvolt-Bordnetz getrennt werden können.

Dadurch, dass der Wert des Stromintegrals bei jeder Änderung der Stromrichtung der Summe der elektrischen Ströme auf Null gesetzt wird, lässt sich ein möglicher Fehlerzustand zuverlässig erkennen.

Gemäß einer vorteilhaften Ausgestaltung des Verfahrens kann der Fehlerzustand aus einem Vergleich eines Betrags des Stromintegrals mit einem vorgegebenen Schwellwert abgeleitet werden. Der Vergleich mit einem vorgegebenen Schwellwert gewährleistet, dass die Zahl an irrtümlich auf Fehler erkannten Zuständen durch die Überwachungsvorrichtung minimiert werden kann.

Gemäß einer vorteilhaften Ausgestaltung des Verfahrens kann das Stromintegral gefiltert werden, um einen Offset-Fehler bei der Bestimmung über die Summe der elektrischen Ströme zu kompensieren. Dadurch kann sichergestellt werden, dass die Fehlererkennung nicht durch Artefakte bei der Bestimmung des Stromintegrals beeinträchtigt wird.

Weitere Vorteile ergeben sich aus der folgenden Zeichnungsbeschreibung. In den Zeichnungen ist ein Ausführungsbeispiel der Erfindung dargestellt. Die Zeichnungen, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Dabei zeigen:
- Fig. 1: eine Systemübersicht eines an eine Ladeeinrichtung angeschlossenen Hochvolt-Bordnetzes eines elektrisch betreibbaren Fahrzeugs mit einer Überwachungsvorrichtung nach einem Ausführungsbeispiel der Erfindung; und
- Fig. 2: das an die Ladeeinrichtung angeschlossene Hochvolt-Bordnetz nach Figur 1 mit einem Körperschluss der negativen Ladeleitung über einen Fehlerwiderstand nach Masse.

In den Figuren sind gleiche oder gleichartige Komponenten mit gleichen Bezugszeichen beziffert. Die Figuren zeigen lediglich Beispiele und sind nicht beschränkend zu verstehen.

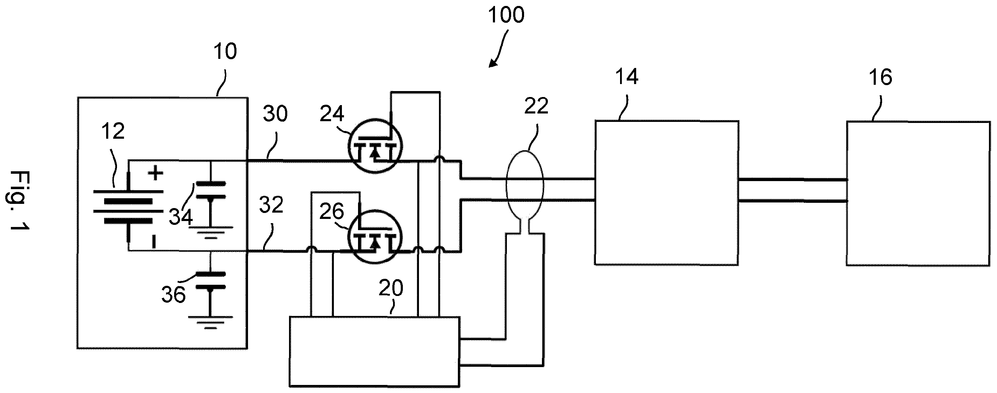

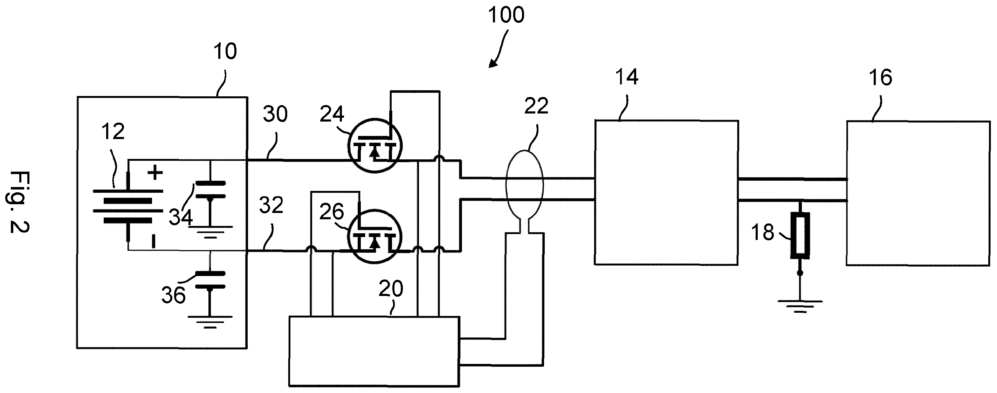

Figur 1 zeigt eine Systemübersicht eines an eine Ladeeinrichtung 16 angeschlossenen Hochvolt-Bordnetzes 10 eines elektrisch betreibbaren Fahrzeugs mit einer Überwachungsvorrichtung 100 nach einem Ausführungsbeispiel der Erfindung. Figur 2 zeigt das an die Ladeeinrichtung 16 angeschlossene Hochvolt-Bordnetz 10 nach Figur 1 mit einem Körperschluss der negativen Ladeleitung 32 über einen Fehlerwiderstand 18 nach Masse.

Das Hochvolt-Bordnetz 100 umfasst einen Hochvolt-Energiespeicher 12, welcher mit einer elektrisch positiven und einer elektrisch negativen Ladeleitung 30, 32 gekoppelt ist, sowie die elektrisch positive Ladeleitung 30 und die elektrisch negative Ladeleitung 32, welche zum Laden des Hochvolt-Energiespeichers 12 über einen Ladeanschluss 14 mit einer positiven, bzw. negativen elektrischen Spannung einer Ladeeinrichtung 16 verbunden sind. Die beiden Ladeleitungen 30, 32 sind zur Sicherstellung der elektromagnetischen Verträglichkeit (EMV) des Hochvolt-Bordnetzes 10 innerhalb des Hochvolt-Bordnetzes 10 über Y-Kapazitäten 34, 36 mit der Masse verbunden.

Zwischen dem Hochvolt-Bordnetz 10 und dem Ladeanschluss 14 ist die Überwachungsvorrichtung 100 angeordnet, welche eine Steuereinheit 20 mit einem Stromsensor 22 aufweist.

Der Stromsensor 22 ist zum Bestimmen einer Summe der elektrischen Ströme der positiven Ladeleitung 30 und der negativen Ladeleitung 32 ausgebildet. Der Stromsensor 22 kann vorzugsweise ausgebildet sein, die Summe der Ströme über ein gemeinsames Magnetfeld der positiven und der negativen Ladeleitung 30, 32 zu bestimmen. Dazu kann der Stromsensor 22 beispielsweise als Hall-Sensor, insbesondere als sogenannter Open-Loop-Hall-Sensor, ausgebildet sein. Alternativ kann das Magnetfeld auch mit einem magneto-resistiven Sensor gemessen werden. Eine weitere Möglichkeit ist, einen Transformator einzusetzen, und so nur den Wechselstromanteil zu betrachten, welcher dann beispielsweise gefiltert werden kann.

In der positiven und negativen Ladeleitung 30, 32 ist jeweils ein Schaltelement 24, 26, insbesondere ein Halbleiterschalter 24, 26 angeordnet, welcher von der Steuereinheit 20 angesteuert werden kann. Auf diese Weise kann bei Erkennen des Fehlerzustands die positive Ladeleitung 30 und die negative Ladeleitung 32 von dem Hochvolt-Bordnetz 10 getrennt werden.

Als Halbleiterschalter 24, 26 können vorteilhaft Feldeffekttransistoren (FETs) eingesetzt werden. Beispielsweise können so SiC-FETs, GaN-FETs oder sogar normale Si-FETs verwendet werden.

Nach dem erfindungsgemäßen Verfahren kann mittels der Überwachungsvorrichtung 100 ein Abschalten des Ladestroms vor Erreichen kritischer Werte einer Körperdurchströmung bewirkt werden. Dazu wird die Summe der Ströme der positiven und negativen Ladeleitungen 30, 32, also der Summe des positiv gerichteten Stroms der positiven Ladeleitung 30 und des negativ gerichteten Stroms der negativen Ladeleitung 32, bestimmt. Die Summe der Ströme wird mit dem Stromsensor 22 bestimmt.

Wird über diesen Pfad ein Fehlerzustand erkannt, werden die beiden Ladeleitungen 30, 32 durch die unidirektionalen Halbleiterschalter 24, 26 unterbrochen. Die Erkennung des Fehlerzustands kann dabei beispielsweise auf einem Stromintegral basieren, das bei jeder Änderung der Stromrichtung auf Null gesetzt wird und dessen Betrag mit einem Schwellwert verglichen wird.

Die Werte des Stromintegrals können bedarfsweise auch gefiltert werden, um Offsetfehler in der Summe der Ströme zu kompensieren. Der Fehlerzustand kann so aus einem zeitlichen Verlauf eines Stromintegrals der Summe der elektrischen Ströme abgeleitet werden.

Eine Gefährdung durch ein Berühren des Leiters im Ladepfad kann somit unabhängig vom Energieinhalt von fahrzeugseitigen Y-Kapazitäten 34, 36 verhindert werden.

Tritt ein Fehlerwiderstand 18, wie bei dem in Figur 2 dargestellten Beispiel erkennbar, zwischen einer der Ladeleitungen 30, 32 gegen Masse, beispielsweise durch einen Körperschluss, auf, so ändert sich dadurch das mit dem Stromsensor 22 und der Steuereinheit 20 registrierte Stromintegral. Die Steuereinheit 20 kann daraufhin die beiden Halbleiterschalter 24, 26 öffnen, sodass die Ladeleitungen 30, 32 von dem Hochvolt-Bordnetz 10 getrennt sind.

Auf diese Weise kann eine mögliche Gefährdung durch den Körperschluss, welcher über den Fehlerwiderstand 18 gekennzeichnet ist, vermieden werden. Durch die kurze Schaltzeit der Halbleiterschalter 24, 26 kann ein rechtzeitiges Öffnen der Kontakte der Ladeleitungen 30, 32 erfolgen.

### Bezugszeichenliste

- 10: Hochvolt-Bordnetz
- 12: Hochvolt-Energiespeicher
- 14: Ladeanschluss
- 16: Ladeeinrichtung
- 18: Fehlerwiderstand
- 20: Steuereinheit
- 22: Stromsensor
- 24: Schaltelement
- 26: Schaltelement
- 30: positive Ladeleitung
- 32: negative Ladeleitung
- 34: Y-Kapazität
- 36: Y-Kapazität
- 100: Überwachungsvorrichtung

## Patentansprüche

1. Überwachungsvorrichtung (100) für ein Hochvolt-Bordnetz (10) eines elektrisch betreibbaren Fahrzeugs,
wobei das Hochvolt-Bordnetz (10) wenigstens umfasst
- einen Hochvolt-Energiespeicher (12), welcher mit einer elektrisch positiven und einer elektrisch negativen Ladeleitung (30, 32) koppelbar ist,
- die elektrisch positive Ladeleitung (30), welche zum Laden des Hochvolt-Energiespeichers (12) über einen Ladeanschluss (14) mit einer positiven elektrischen Spannung einer Ladeeinrichtung (16) koppelbar ist,
- die elektrisch negative Ladeleitung (32), welche zum Laden des Hochvolt-Energiespeichers (12) über den Ladeanschluss (14) mit einer negativen elektrischen Spannung der Ladeeinrichtung (16) koppelbar ist,
wobei die Überwachungsvorrichtung (100) eine Steuereinheit (20) mit wenigstens einem Stromsensor (22) aufweist, welcher zum Bestimmen einer Summe der elektrischen Ströme der positiven Ladeleitung (30) und der negativen Ladeleitung (32) ausgebildet ist,
wobei die Steuereinheit (20) ausgebildet ist, bei Erkennen eines Fehlerzustands die positive Ladeleitung (30) und die negative Ladeleitung (32) von dem Hochvolt-Bordnetz (10) zu trennen,
**dadurch gekennzeichnet, dass** die Steuereinheit ausgebildet ist, den Fehlerzustand aus einem zeitlichen Verlauf eines Stromintegrals der Summe der elektrischen Ströme abzuleiten und
einen Wert des Stromintegrals bei jeder Änderung der Stromrichtung der Summe der elektrischen Ströme auf Null zu setzen.

2. Überwachungsvorrichtung nach Anspruch 1, wobei der wenigstens eine Stromsensor (22) ausgebildet ist, die Summe der Ströme über ein gemeinsames Magnetfeld der positiven und der negativen Ladeleitung (30, 32) zu bestimmen.

3. Überwachungsvorrichtung nach Anspruch 1 oder 2, wobei der wenigstens eine Stromsensor (22) als wenigstens einer von einem Hall-Sensor, insbesondere einem Open-Loop-Hall-Sensor, einem magneto-resistiven Sensor, einem Transformator ausgebildet ist.

4. Überwachungsvorrichtung nach einem der vorhergehenden Ansprüche, wobei in der positiven und negativen Ladeleitung (30, 32) jeweils ein Schaltelement (24, 26), insbesondere ein Halbleiterschalter (24, 26) angeordnet ist, um bei Erkennen des Fehlerzustands die positive Ladeleitung (30) und die negative Ladeleitung (32) von dem Hochvolt-Bordnetz (10) zu trennen.

5. Überwachungsvorrichtung nach einem der vorhergehenden Ansprüche, wobei die Steuereinheit (20) ausgebildet ist, das Erkennen des Fehlerzustands aus dem zeitlichen Verlauf des Stromintegrals der Summe der elektrischen Ströme abzuleiten.

6. Verfahren zum Betreiben einer Überwachungsvorrichtung (100) für ein Hochvolt-Bordnetz (10) eines elektrisch betreibbaren Fahrzeugs nach einem der vorhergehenden Ansprüche, wobei das Hochvolt-Bordnetz (10) wenigstens umfasst
- einen Hochvolt-Energiespeicher (12), welcher mit einer elektrisch positiven und einer elektrisch negativen Ladeleitung (30, 32) koppelbar ist,
- die elektrisch positive Ladeleitung (30), welche zum Laden des Hochvolt-Energiespeichers (12) über einen Ladeanschluss (14) mit einer positiven elektrischen Spannung einer Ladeeinrichtung (16) koppelbar ist,
- die elektrisch negative Ladeleitung (32), welche zum Laden des Hochvolt-Energiespeichers (12) über den Ladeanschluss (14) mit einer negativen elektrischen Spannung der Ladeeinrichtung (16) koppelbar ist,
wobei die Überwachungsvorrichtung (100) eine Steuereinheit (20) mit wenigstens einem Stromsensor (22) aufweist,
wobei mittels des Stromsensors (22) eine Summe der elektrischen Ströme der positiven Ladeleitung (30) und der negativen Ladeleitung (32) bestimmt wird, wobei bei Erkennen eines Fehlerzustands durch die Steuereinheit (20) die positive Ladeleitung (30) und die negative Ladeleitung (32) von dem Hochvolt-Bordnetz (10) getrennt werden,
**dadurch gekennzeichnet, dass**
der Fehlerzustand aus einem zeitlichen Verlauf eines Stromintegrals der Summe der elektrischen Ströme abgeleitet wird, und
ein Wert des Stromintegrals bei jeder Änderung der Stromrichtung der Summe der elektrischen Ströme auf Null gesetzt wird.

7. Verfahren nach Anspruch 6, wobei der Fehlerzustand aus einem Vergleich eines Betrags des Stromintegrals mit einem vorgegebenen Schwellwert abgeleitet wird.

8. Verfahren nach einem der Ansprüche 6 bis 7, wobei das Stromintegral gefiltert wird, um einen Offset-Fehler bei der Bestimmung des Stromsignals über die Summe der elektrischen Ströme zu kompensieren.

## Claims

1. Monitoring device (100) for a high-voltage onboard electrical system (10) of an electrically operatable vehicle,
wherein the high-voltage onboard electrical system (10) at least comprises
- a high-voltage energy storage device (12), which can be coupled to an electrically positive and an electrically negative charge line (30, 32),
- the electrically positive charge line (30), which can be coupled to a positive electric voltage of a charging device (16) via a charging connection (14) in order to charge the high-voltage energy storage device (12),
- the electrically negative charge line (32), which can be coupled to a negative electric voltage of the charging device (16) via the charging connection (14) in order to charge the high-voltage energy storage device (12),
wherein the monitoring device (100) has a control unit (20) with at least one current sensor (22) that is designed to determine a sum of the electric currents of the positive charge line (30) and of the negative charge line (32),
wherein the control unit (20) is designed to separate the positive charge line (30) and the negative charge line (32) from the high-voltage onboard electrical system (10) upon detection of a fault,
**characterized in that** the control unit is designed to infer the fault from a temporal profile of a current integral of the sum of the electric currents and to set a value of the current integral to zero upon each change of the current direction of the sum of the electric currents.

2. Monitoring device according to Claim 1, wherein the at least one current sensor (22) is designed to determine the sum of the currents via a common magnetic field of the positive and the negative charge line (30, 32).

3. Monitoring device according to Claim 1 or 2, wherein the at least one current sensor (22) is designed as at least one of a Hall sensor, in particular an open-loop Hall sensor, a magnetoresistive sensor and a transformer.

4. Monitoring device according to one of the preceding claims, wherein a switching element (24, 26), in particular a semiconductor switch (24, 26), is arranged in the positive and negative charge line (30, 32) in each case, in order to separate the positive charge line (30) and the negative charge line (32) from the high-voltage onboard electrical system (10) upon detection of the fault.

5. Monitoring device according to one of the preceding claims, wherein the control unit (20) is designed to infer the detection of the fault from the temporal profile of the current integral of the sum of the electric currents.

6. Method for operating a monitoring device (100) for a high-voltage onboard electrical system (10) of an electrically operatable vehicle according to one of the preceding claims, wherein the high-voltage onboard electrical system (10) at least comprises
- a high-voltage energy storage device (12), which can be coupled to an electrically positive and an electrically negative charge line (30, 32),
- the electrically positive charge line (30), which can be coupled to a positive electric voltage of a charging device (16) via a charging connection (14) in order to charge the high-voltage energy storage device (12),
- the electrically negative charge line (32), which can be coupled to a negative electric voltage of the charging device (16) via the charging connection (14) in order to charge the high-voltage energy storage device (12),
wherein the monitoring device (100) has a control unit (20) with at least one current sensor (22),
wherein a sum of the electric currents of the positive charge line (30) and of the negative charge line (32) is determined by means of the current sensor (22),
wherein the positive charge line (30) and the negative charge line (32) are separated from the high-voltage onboard electrical system (10) when the control unit (20) detects a fault,
**characterized in that**
the fault is inferred from a temporal profile of a current integral of the sum of the electric currents, and
a value of the current integral is set to zero upon each change of the current direction of the sum of the electric currents.

7. Method according to Claim 6, wherein the fault is inferred from a comparison of an absolute value of the current integral to a prescribed threshold value.

8. Method according to either of Claims 6 and 7, wherein the current integral is filtered in order to compensate for an offset error during determination of the current signal via the sum of the electric currents.

## Revendications

1. Dispositif de surveillance (100) pour un réseau de bord haute tension (10) d'un véhicule à fonctionnement électrique ;
le réseau de bord haute tension (10) comprenant au moins
- un accumulateur d'énergie haute tension (12), lequel peut être couplé à un câble de charge électriquement positif et un électriquement négatif (30, 32),
- le câble de charge électriquement positif (30), lequel peut être couplé à une tension électrique positive d'un dispositif de charge (16) par le biais d'une borne de charge (14) en vue de charger l'accumulateur d'énergie haute tension (12),
- le câble de charge électriquement négatif (32), lequel peut être couplé à une tension électrique négative du dispositif de charge (16) par le biais de la borne de charge (14) en vue de charger l'accumulateur d'énergie haute tension (12),
le dispositif de surveillance (100) possédant une unité de commande (20) comprenant au moins un capteur de courant (22), lequel est configuré pour déterminer une somme des courants électriques du câble de charge positif (30) et du câble de charge négatif (32),
l'unité de commande (20) étant configurée pour, lors de la reconnaissance d'un état de défaut, déconnecter le câble de charge positif (30) et le câble de charge négatif (32) du réseau de bord haute tension (10),
**caractérisé en ce que** l'unité de commande est configurée pour dériver l'état de défaut à partir d'une évolution temporelle d'une intégrale de courant de la somme des courants électriques et pour fixer à zéro une valeur de l'intégrale de courant à chaque modification du sens du courant de la somme des courants électriques.

2. Dispositif de surveillance selon la revendication 1, l'au moins un capteur de courant (22) étant configuré pour déterminer la somme des courants par le biais d'un champ magnétique commun des câbles de charge positif et négatif (30, 32).

3. Dispositif de surveillance selon la revendication 1 ou 2, l'au moins un capteur de courant (22) étant réalisé sous la forme d'au moins l'un parmi un capteur à effet Hall, en particulier un capteur à effet Hall à boucle ouverte, un capteur magnétorésistif, un transformateur.

4. Dispositif de surveillance selon l'une des revendications précédentes, un élément de commutation (24, 26), en particulier un commutateur à semiconducteur (24, 26), étant respectivement disposé dans les câbles de charge positif et négatif (30, 32), afin de déconnecter le câble de charge positif (30) et le câble de charge négatif (32) du réseau de bord haute tension (10) lors de la reconnaissance de l'état de défaut.

5. Dispositif de surveillance selon l'une des revendications précédentes, l'unité de commande (20) étant configurée pour dériver la reconnaissance de l'état de défaut à partir de l'évolution temporelle de l'intégrale de courant de la somme des courants électriques.

6. Procédé pour faire fonctionner un dispositif de surveillance (100) pour un réseau de bord haute tension (10) d'un véhicule à fonctionnement électrique selon l'une des revendications précédentes, le réseau de bord haute tension (10) comprenant au moins
- un accumulateur d'énergie haute tension (12), lequel peut être couplé à un câble de charge électriquement positif et un électriquement négatif (30, 32),
- le câble de charge électriquement positif (30), lequel peut être couplé à une tension électrique positive d'un dispositif de charge (16) par le biais d'une borne de charge (14) en vue de charger l'accumulateur d'énergie haute tension (12),
- le câble de charge électriquement négatif (32), lequel peut être couplé à une tension électrique négative du dispositif de charge (16) par le biais de la borne de charge (14) en vue de charger l'accumulateur d'énergie haute tension (12),
le dispositif de surveillance (100) possédant une unité de commande (20) comprenant au moins un capteur de courant (22),
une somme des courants électriques du câble de charge positif (30) et du câble de charge négatif (32) étant déterminée au moyen du capteur de courant (22),
en cas de reconnaissance d'un état de défaut par l'unité de commande (20), le câble de charge positif (30) et le câble de charge négatif (32) étant déconnectés du réseau de bord haute tension (10),
**caractérisé en ce que** l'état de défaut est dérivé à partir d'une évolution temporelle d'une intégrale de courant de la somme des courants électriques, et
une valeur de l'intégrale de courant est fixée à zéro à chaque modification du sens du courant de la somme des courants électriques change.

7. Procédé selon la revendication 6, l'état de défaut étant dérivé à partir d'une comparaison d'une valeur absolue de l'intégrale de courant avec une valeur de seuil prédéfinie.

8. Procédé selon l'une des revendications 6 à 7, l'intégrale de courant étant filtrée afin de compenser une erreur de décalage lors de la détermination du signal de courant sur la somme des courants électriques.
